(19) Europäisches Patentamt / European Patent Office / Office européen des brevets

(11) **EP 4 102 579 A1**

(12) **DEMANDE DE BREVET EUROPEEN**

(43) Date de publication:
**14.12.2022 Bulletin 2022/50**

(21) Numéro de dépôt: **22177631.3**

(22) Date de dépôt: **07.06.2022**

(51) Classification Internationale des Brevets (IPC):
**H01L 33/00** (2010.01)   **H01L 33/12** (2010.01)
**H01L 21/02** (2006.01)

(52) Classification Coopérative des Brevets (CPC):
**H01L 33/0075; H01L 21/02002; H01L 21/02458; H01L 21/02513; H01L 21/0254; H01L 21/306; H01L 21/30635; H01L 21/3081; H01L 21/3083; H01L 21/7624; H01L 33/12;** H01L 33/0093

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**KH MA MD TN**

(30) Priorité: **07.06.2021 FR 2105989**

(71) Demandeurs:
• **Commissariat à l'énergie atomique et aux énergies alternatives 75015 Paris (FR)**
• **CENTRE NATIONAL DE LA RECHERCHE SCIENTIFIQUE 75794 Paris Cedex 16 (FR)**

(72) Inventeurs:
• **DUSSAIGNE, Amélie 38054 Grenoble CEDEX 09 (FR)**
• **DAMILANO, Benjamin 75016 PARIS (FR)**
• **PERNEL, Carole 38054 GRENOBLE CEDEX 09 (FR)**
• **VEZIAN, Stéphane 75016 PARIS (FR)**

(74) Mandataire: **Brevalex 95, rue d'Amsterdam 75378 Paris Cedex 8 (FR)**

(54) **PROCÉDÉ POUR FABRIQUER UN SUBSTRAT COMPRENANT UNE COUCHE D'INGAN RELAXÉE ET SUBSTRAT AINSI OBTENU POUR LA REPRISE DE CROISSANCE D'UNE STRUCTURE LED**

(57) Procédé pour fabriquer une couche d'InGaN épitaxiée relaxée à partir d'un substrat GaN/InGaN comprenant les étapes suivantes :
a) fournir un premier empilement (10) comprenant une couche à porosifier en GaN ou InGaN (13) et une couche barrière (14),
b) reporter la couche à porosifier en GaN ou InGaN (13) et la couche barrière (14) sur un support de porosification (21), de manière à former un deuxième empilement (20),
c) former un masque (50) sur la couche à porosifier en GaN ou InGaN (13),
d) porosifier la couche en GaN ou InGaN (13) à travers le masque (50),
e) reporter la couche porosifiée en GaN ou InGaN (13) et la couche barrière (14) sur un support d'intérêt (31),
f) former une couche d'InGaN (41) par épitaxie sur la couche barrière (14), moyennant quoi on obtient une couche d'InGaN épitaxiée relaxée.

FIG.1A   FIG.1B   FIG.1C   FIG.1D

FIG.1E   FIG.1F   FIG.1G

EP 4 102 579 A1

## Description

## DOMAINE TECHNIQUE

La présente invention se rapporte au domaine général des micro-écrans couleur.

L'invention concerne un procédé pour fabriquer un substrat ou un pseudo-substrat comprenant une couche d'InGaN relaxée.

L'invention concerne également un substrat ou un pseudo-substrat comprenant une couche d'InGaN relaxée.

L'invention trouve des applications dans de nombreux domaines industriels, et notamment dans le domaine des micro-écrans couleur à base de micro-LEDs au pas inférieur à 10 $\mu$m.

## ÉTAT DE LA TECHNIQUE ANTÉRIEURE

Les micro-écrans couleurs comprennent des pixels rouges, verts et bleus (pixels RGB).

Les pixels bleus et verts peuvent être fabriqués à base de matériaux nitrures et les pixels rouges à base de matériaux phosphores. Pour combiner sur le même substrat ces trois types de pixels, la technique dite de « pick and place » est généralement utilisée. Cependant, dans le cas des micro-écrans avec des pixels inférieurs à 10 $\mu$m, cette technique ne peut plus être utilisée à cause, non seulement, des problèmes d'alignement, mais aussi du temps nécessaire pour réaliser une telle technique à l'échelle d'un micro-écran.

Une autre solution consiste à réaliser la conversion de couleurs avec des boîtes quantiques (QD pour « Quantum Dot » en langue anglaise) ou des nanophosphores. Cependant, le contrôle du dépôt de ces matériaux sur des pixels de faibles dimensions est difficile et leur tenue au flux n'est pas suffisamment robuste.

Il est donc crucial de pouvoir obtenir les trois pixels RGB de façon native avec la même famille de matériaux et sur le même substrat. Pour cela, l'InGaN est le matériau le plus prometteur. Ce matériau peut, en effet, théoriquement couvrir tout le spectre visible en fonction de sa concentration en indium. Les micro-LEDs bleues à base d'InGaN montrent déjà une luminance élevée, bien supérieure à leurs homologues organiques. Pour émettre à des longueurs d'onde dans le vert, les puits quantiques (PQs) de la LED doivent contenir au moins 25% d'indium et pour une émission dans le rouge, il est nécessaire d'avoir au moins 35% d'indium. Malheureusement, la qualité du matériau InGaN au-delà de 20% d'In est dégradée en raison de la faible miscibilité de l'In dans le GaN, mais aussi en raison de la forte contrainte compressive inhérente à la croissance de la zone active InGaN sur GaN.

Il est donc essentiel de pouvoir réduire la contrainte globale dans les structures à base de GaN/InGaN.

Pour remédier à cette problématique, plusieurs solutions ont été envisagées.

Une première solution consiste à former des nanostructures, comme des nanofils ou des pyramides, pour pouvoir relaxer les contraintes par les bords libres. La croissance des nanofils axiaux peut être réalisée par épitaxie par jets moléculaires (ou MBE pour Molecular Beam Epitaxy »). En pratique, la faible température de croissance utilisée en croissance par MBE conduit à des faibles rendements quantiques internes (IQE). Les pyramides permettent de courber les dislocations. En particulier, les pyramides complètes ont des plans semi-polaires favorables à l'incorporation d'In et à la réduction du champ électrique interne de la zone active. Pour des pyramides tronquées, les faces tronquées permettent une croissance des puits quantiques sur le plan c, ce qui conduit à une émission plus homogène par rapport à une émission le long des plans semi-polaires d'une pyramide complète. Alternativement, la croissance peut aussi se faire en planaire sur des plans autres que la face c de la structure wurtzite comme la croissance sur les plans semi-polaires qui sont plus favorables à l'incorporation d'In.

Une autre solution consiste à réduire les contraintes dans la zone active de la structure LED en utilisant un substrat (ou pseudo-substrat) avec un paramètre de maille plus proche du paramètre de maille de l'alliage InGaN des puits quantiques. Ainsi, même avec une configuration planaire, on peut augmenter le taux d'incorporation d'In dans l'InGaN. Il a été montré que, lorsque le paramètre de maille du substrat augmente, le champ électrique interne est réduit et les émissions des puits quantiques sont décalées vers le rouge. La couche relaxée d'InGaN obtenue permet de faire croitre une hétérostructure III-N par épitaxie en phase vapeur aux organométalliques (ou MOVPE pour « MetalOrganic Vapor Phase Epitaxy »). Cependant, à ce jour, à notre connaissance, le seul substrat ayant permis cette démonstration est le pseudo-substrat InGaNOS de Soitec. Il est fabriqué en mettant en œuvre la technique du Smart Cut™. La relaxation de la couche d'InGaN est obtenue à travers différents traitements thermiques [1]. Cependant, avec un tel procédé, des fissures peuvent apparaître dans la couche d'InGaN et/ou la surface de cette couche peut perdre sa planéité.

Récemment, il a été montré que le GaN poreux pouvait être compliant [2]. Une couche d'$In_xGa_{1-x}N$ avec $0,05 \leq x \leq 0,125$ de 200 nm est formée sur une couche de GaN dopée n de 800 nm, puis des mésas de 10 $\mu$m de côté sont structurées. La porosification par anodisation électrochimique de la couche de GaN type n conduit à une relaxation partielle de la couche d'InGaN supérieure. Des micro-LEDs rouges avec un EQE de 0,2% ont pu être élaborées à partir d'un procédé similaire [3].

Cependant, avec un tel procédé la couche à porosifier doit être dopée. De plus, la porosification se fait uniquement par les faces latérales des mésas. Il est donc difficile d'obtenir une porosité uniforme dans tout le volume de la couche de GaN.

La fabrication d'une couche d'InGaN épitaxiée relaxée à partir d'un substrat GaN/InGaN et la fabrication d'une couche d'InGaN épitaxiée relaxée sur des mésas d'InGaN ont été réalisées avec des procédés mettant en œuvre une porosification électrochimique. L'étape de porosification est mise en œuvre pleine plaque grâce à différents reports [4,5].

Une autre technique pour porosifier une couche de GaN consiste à déposer un nano-masque sur la couche de GaN à porosifier et à sublimer cette couche à travers les ouvertures du masque grâce à un recuit à haute température. La taille des pores et leur densité dépendent donc d'abord des dimensions du masque. Des dispositifs comprenant une couche poreuse de GaN et des puits quantiques (Ga, In)N/GaN ont été fabriqués à partir d'un empilement comprenant successivement un support en silicium, une couche en AlN, une couche de GaN, une couche d'InGaN et une couche de GaN. Après avoir formé un masque pleine plaque sur cet empilement, ce dernier est soumis à l'étape de sublimation. La couche de GaN ainsi que les couches qui le recouvrent sont sublimées à travers le masque. La couche d'AlN joue le rôle de couche d'arrêt. Il a été démontré que l'utilisation d'un substrat de GaN poreux conduit à une meilleure photoluminescence par rapport à un substrat de GaN non poreux [6]. La sublimation peut se faire, par exemple, dans un bâti d'épitaxie par jets moléculaires (EJM) [6] ou dans un bâti d'épitaxie en phase vapeur aux organométalliques (EPVOM) [7]. Ce procédé peut être mis en œuvre sur des couches de GaN dopées ou non dopées. Cependant, tous les substrats ne peuvent pas être utilisés étant donné les températures mises en œuvre lors de la sublimation.

**EXPOSÉ DE L'INVENTION**

Un but de la présente invention est de proposer un procédé d'obtenir une couche d'InGaN épitaxiée, au moins partiellement voire totalement relaxée, à partir d'un substrat GaN/InGaN en vue de fabriquer, par exemple, des pixels rouge vert bleu.

Pour cela, la présente invention propose un procédé pour fabriquer une couche d'InGaN épitaxiée relaxée à partir d'un substrat GaN/InGaN comprenant les étapes suivantes :

a) fournir un premier empilement comprenant successivement une couche à porosifier en GaN ou In-GaN et une couche barrière, de préférence en AlInN, AlN, GaN ou AlGaN,
b) reporter la couche à porosifier en GaN ou InGaN et la couche barrière sur un support de porosification, la couche barrière étant disposée entre le support de porosification et la couche à porosifier en GaN ou InGaN, de manière à former un deuxième empilement,
c) former un masque sur la couche à porosifier en GaN ou InGaN,
d) porosifier la couche en GaN ou InGaN à travers le masque, moyennant quoi on forme une couche poreuse en GaN ou InGaN,
e) reporter la couche poreuse en GaN ou InGaN et la couche barrière sur un support d'intérêt, moyennant quoi on forme un substrat intermédiaire,
f) former une couche d'InGaN par épitaxie sur la couche barrière, moyennant quoi on obtient une couche d'InGaN épitaxiée relaxée sur le substrat intermédiaire.

L'invention se distingue fondamentalement de l'art antérieur par la mise en œuvre d'une étape de porosification de la couche de GaN ou d'InGaN à travers un masque et par la mise en œuvre de différentes étapes de report. La porosification structure la surface de la couche de GaN ou d'InGaN et permet d'améliorer l'efficacité d'extraction et permet d'incorporer plus d'In par relaxation des contraintes.

Le premier report permet de réaliser l'étape de porosification sur la face de la couche de GaN ou d'InGaN de polarité azote (N), le degré de porosification est ainsi obtenu plus facilement par rapport à la face de polarité Ga. Le second report permet d'avoir la couche barrière non porosifiée en face avant du substrat, pour une reprise d'épitaxie ultérieure. La couche barrière n'est pas porosifiée lors de l'étape e). Elle peut donc servir de couche de reprise d'épitaxie. De plus, le substrat utilisé pour la porosification n'est pas le substrat final, ce qui autorise un plus large choix de substrats d'intérêt.

A l'issue du procédé, on obtient une structure de type InGaNOX (« InGaN on Substrate X») avec une couche d'InGaN non dopée. Le procédé peut être réalisé pleine plaque, ce qui simplifie sa mise en œuvre.

Lors de la reprise d'épitaxie, la température de croissance utilisée (typiquement de 800°C à 1000°C, et en particulier de 800°C à 900°C pour l'InGaN) permet de modifier la couche porosifiée, notamment en élargissant les pores de cette couche, ce qui apporte un degré de liberté supplémentaire tout en conservant le paramètre de maille adapté à la couche ré-épitaxiée. On obtient ainsi une couche d'InGaN au moins partiellement relaxée, et de préférence totalement relaxée.

Selon une première variante de réalisation, l'étape d) est réalisée par sublimation à travers le masque. La porosification par sublimation consiste à sublimer la couche de GaN ou d'InGaN à travers les ouvertures du masque. La taille des pores et leur densité dépendent donc d'abord des dimensions du masque. La sublimation consiste en un recuit à haute température. Elle peut se faire par exemple dans un bâti d'épitaxie par jets moléculaires ou dans un bâti d'épitaxie en phase vapeur aux organométalliques (EPVOM).

Selon cette première variante, le masque est, avantageusement, un masque en SiN. Le masque en SiN peut être, avantageusement, formé *in situ.* La position des ouvertures du masque peut être aléatoire. Alternativement, le masque SiN peut être formé *ex situ* avec un procédé mettant en œuvre une étape de gravure à travers un masque organisé, par exemple un masque en copolymère à bloc. La couche barrière est sélective par rapport au (Ga,In)N lors de la sublimation.

Selon une autre variante de réalisation, la couche à porosifier de GaN ou d'InGaN est dopée et l'étape d) est réalisée par voie électrochimique à travers le masque.

Selon cette variante, le masque est avantageusement, en un matériau polymère. De préférence, il s'agit d'un copolymère à bloc. Un tel polymère présente des ouvertures homogènes et régulièrement espacées.

Selon ces différentes variantes de réalisation, le masque formé à l'étape c) peut avoir des ouvertures de 10nm à 50nm de diamètre. Par exemple, on choisira des ouvertures de 10nm à 20nm ou encore des ouvertures de 20nm à 40nm de diamètre.

Il est facile d'ajuster les dimensions des pores de la couche poreuse en fonction des ouvertures du masque, du dopage éventuel de la couche de GaN ou d'InGaN, de la tension appliquée et/ou de l'électrolyte choisi (nature et/ou concentration) ou encore de la température et de la durée de sublimation pour avoir le pourcentage de relaxation nécessaire pour atteindre la longueur d'onde désirée.

Avantageusement, le masque comporte au moins une première zone, une deuxième zone et une troisième zone, les ouvertures de la première zone ayant une première dimension, les ouvertures de la deuxième zone ayant une deuxième dimension et les ouvertures de la troisième zone ayant une troisième dimension, moyennant quoi lors de l'étape d) la couche poreuse en GaN ou InGaN présente un premier degré de porosité, un deuxième degré de porosité et un troisième degré de porosité en regard respectivement de la première zone, de la deuxième zone et de la troisième zone. Ainsi, la concentration en In de la couche d'InGaN réépitaxiée dans chacune des zones sera différente, et il est possible d'épitaxier une structure LED tout InGaN. Une seule étape de croissance peut conduire à l'obtention des trois couleurs RGB.

Avantageusement, le support de porosification et/ou le support d'intérêt comprend une couche support, par exemple en saphir, en carbure de silicium (SiC) ou en silicium, et une couche d'oxyde enterré.

Selon un mode de réalisation particulier, l'étape b) est, avantageusement, réalisée selon un procédé, de type SmartCut™, comprenant les étapes suivantes :

- implantation d'espèces atomiques pour former une zone de fragilisation dans la couche à porosifier en GaN ou InGaN, à une profondeur voisine de l'épaisseur finale de la couche à conserver dans le substrat final,

- collage du premier empilement sur le support de porosification, la couche barrière étant disposée entre le support de porosification et la couche à porosifier,

- apport d'énergie thermique pour désolidariser la couche à porosifier de la couche de GaN ou d'InGaN au niveau de la zone de fragilisation.

Avantageusement, le premier empilement fourni à l'étape a) comprend, en outre, une couche d'InGaN additionnelle.

Selon ce mode de réalisation, l'étape b) peut être réalisée selon deux variantes avantageuses.

Selon la première variante de réalisation avantageuse, l'étape b) comporte les étapes suivantes :

- anodisation électrochimique sur la couche d'InGaN additionnelle pour la fragiliser,

- séparation de la couche barrière et de la couche de GaN ou InGaN et de la couche d'InGaN additionnelle, par activation thermique et/ou action mécanique.

Selon la deuxième variante de réalisation avantageuse, l'étape b) comporte une étape au cours de laquelle on réalise une anodisation électrochimique sur la couche additionnelle d'InGaN jusqu'à sa dissolution, moyennant quoi on sépare la couche barrière et la couche de GaN ou d'InGaN de la couche d'InGaN additionnelle. La dissolution de la couche d'InGaN additionnelle peut être réalisée préalablement ou ultérieurement au report des couches sur le support d'anodisation.

Avantageusement, le procédé comporte une étape au cours de laquelle on structure la couche de GaN ou d'InGaN, pour former des mésas de GaN ou d'InGaN. La formation des mésas permet d'introduire un degré de relaxation supplémentaire de la couche d'InGaN qui sera épitaxiée sur la couche barrière, en profitant des bords libres des mésas. La structuration en mésa amplifie le phénomène de relaxation.

La structuration peut être réalisée avant ou après l'étape de porosification.

Par exemple, le procédé comporte, entre l'étape b) et l'étape d), une étape au cours de laquelle on structure la couche barrière et la couche à porosifier en GaN ou InGaN, par exemple par photolithographie, pour former des mésas. Les mésas sont ainsi formées avant l'étape de porosification, ce qui permet de porosifier les mésas à la fois par les faces latérales des mésas et par la face supérieure en contact avec la solution électrolytique.

Les mésas pourraient être formées lors de l'étape de porosification. Pour cela, le masque formé à l'étape c) peut être déposé localement sur la couche en GaN ou InGaN à porosifier, moyennant quoi, lors de l'étape d), on forme des mésas de GaN ou d'InGaN par sublimation des parties de la couche en GaN ou InGaN non couvertes par le masque en même temps que l'on porosifie les parties couvertes par le masque. Avantageusement, le masque est déposé ex-situ.

Avantageusement, les mésas ont une épaisseur pouvant aller d'une dizaine de nanomètres à quelques micromètres en fonction de la nature de la couche 13 des mésas. Une mésa contenant une couche 13 en GaN poreux a par exemple une épaisseur de 500nm à 2 µm. Une mésa contenant une couche 13 en InGaN poreux a par exemple une épaisseur de 10 à 200 nm. Avantageusement, pour des mésas de faible épaisseur (typiquement inférieure à 100nm), la densité de défauts dans les mésas est limitée malgré la forte concentration en In.

Avantageusement, le procédé comprend une étape au cours de laquelle on réalise une étape de dopage par implantation ou par épitaxie en phase vapeur aux organométalliques, éventuellement avec différents dopages, sur la couche de GaN ou d'InGaN. Avantageusement, cette étape est réalisée avant l'étape d) de porosification par électrochimie. Elle peut être réalisée directement sur les mésas d'InGaN ou de GaN.

Il est par exemple possible de réaliser une implantation sélective d'un dopant n (tel que du silicium) ou un dopant p (tel que magnésium) pour obtenir une couche de GaN ou d'InGaN ou des mésas plus ou moins dopées. Ceci permet d'avoir une structure plus ou moins relaxée.

De préférence, on réalise une implantation avec un dopant de type n (Si par exemple) avec des dopages différents d'une mésa à l'autre. On obtient ainsi des pixels, par exemple trois pixels, de niveaux de dopages différents et donc par suite des pourcentages de relaxation différents, et ainsi des longueurs d'onde d'émission différentes. Cette variante de réalisation est avantageuse pour former un dispositif multispectral, par exemple des LEDs de différentes couleurs de façon simplifiée ou micro-écran (« micro-display ») multi couleurs.

Avantageusement, la couche barrière a une épaisseur inférieure à 3nm.

Avantageusement, le taux d'indium présent dans la couche d'InGaN est supérieur ou égal à 8%. Ceci assure une ré-épitaxie de qualité, riche en In.

Avantageusement, le procédé comporte une étape ultérieure au cours de laquelle on forme une structure LED, et en particulier une structure LED rouge tout InGaN, sur les mésas. Ces dernières ayant un paramètre de maille dans le plan supérieur à celui du GaN grâce à la relaxation, elles serviront de pseudo-substrat InGaN pour augmenter le taux d'incorporation d'In dans la structure LED tout InGaN.

Ce procédé présente de nombreux avantages :

- il est simple à mettre en œuvre,
- il peut être utilisé pour des mésas de faibles ou grandes épaisseurs,
- la structuration en mésa apporte l'effet de compliance,
- il conduit à une relaxation partielle ou totale des contraintes, ce qui conduit à diminuer la polarisation piézo-électrique par comparaison à une couche contrainte de même concentration en In, et surtout à incorporer plus d'In pour les mêmes conditions de croissance,

- il permet une approche dite « bottom up » pour la fabrication de µLED et µdisplay : la croissance des structures optiques (N, QW, P) est réalisée après pixellisation en mésa, quel que soit la taille des pixels, et permet de s'affranchir des problèmes d'alignement comme pour le procédé « pick and place »,
- il n'y a pas d'impact du procédé de gravure des pixels sur l'efficacité des micro-LEDs, ce qui rend possible la réalisation de pixel micrométrique voire submicrométrique.

Avec ce procédé, il est possible d'atteindre 40% d'In dans les puits et une efficacité quantique (EQE) supérieure à 2,9 % dans le rouge.

L'invention concerne également un substrat comprenant successivement :

- un support d'intérêt, comprenant, de préférence, une couche support, par exemple en saphir, en SiC ou en silicium, et une couche d'oxyde enterré,- une couche de GaN ou d'InGaN poreuse, éventuellement dopée, la couche de GaN ou d'InGaN ayant, avantageusement, une porosité supérieure à 1%, et de préférence, de 5% à 70%, et
- une couche barrière, de préférence en AlInN, AlN, GaN ou AlGaN,
- éventuellement une couche d'InGaN additionnelle.

La couche barrière n'est pas poreuse.

Un tel substrat permet de former une couche d'InGaN épitaxiée relaxée et ensuite de réaliser une reprise de croissance d'une structure LED émettant dans le rouge. La couche d'InGaN relaxée favorise l'incorporation d'In et permet de conserver une bonne qualité cristalline de l'alliage InGaN même à forte concentration en In.

L'invention concerne également une structure de diode électroluminescente comprenant successivement un substrat tel que défini précédemment et un empilement réépitaxié,

le substrat comprenant :

- un support d'intérêt,
- une couche poreuse en GaN ou InGaN, éventuellement dopée, et ayant, avantageusement, une porosité supérieure à 1%, et de préférence, de 5% à 70%,
- une couche barrière,
- éventuellement, une couche d'InGaN additionnelle.

l'empilement réépitaxié comprenant successivement depuis la couche barrière du substrat ou, le cas échéant depuis la couche d'InGaN additionnelle :

- une couche d'InGaN épitaxiée relaxée dopée d'un premier type de conductivité,

- une zone active avec un ou plusieurs puits quantiques InGaN/(Ga,In)N émettant dans le rouge ou dans le vert, ou dans le bleu pour obtenir les 3 couleurs via les mesa avec différents niveaux de dopage,
- une couche d'InGaN dopée d'un second type de conductivité, différent du premier type de conductivité.

D'autres caractéristiques et avantages de l'invention ressortiront du complément de description qui suit.

Il va de soi que ce complément de description n'est donné qu'à titre d'illustration de l'objet de l'invention et ne doit en aucun cas être interprété comme une limitation de cet objet.

**BRÈVE DESCRIPTION DES DESSINS**

La présente invention sera mieux comprise à la lecture de la description d'exemples de réalisation donnés à titre purement indicatif et nullement limitatif en faisant référence aux dessins annexés sur lesquels :

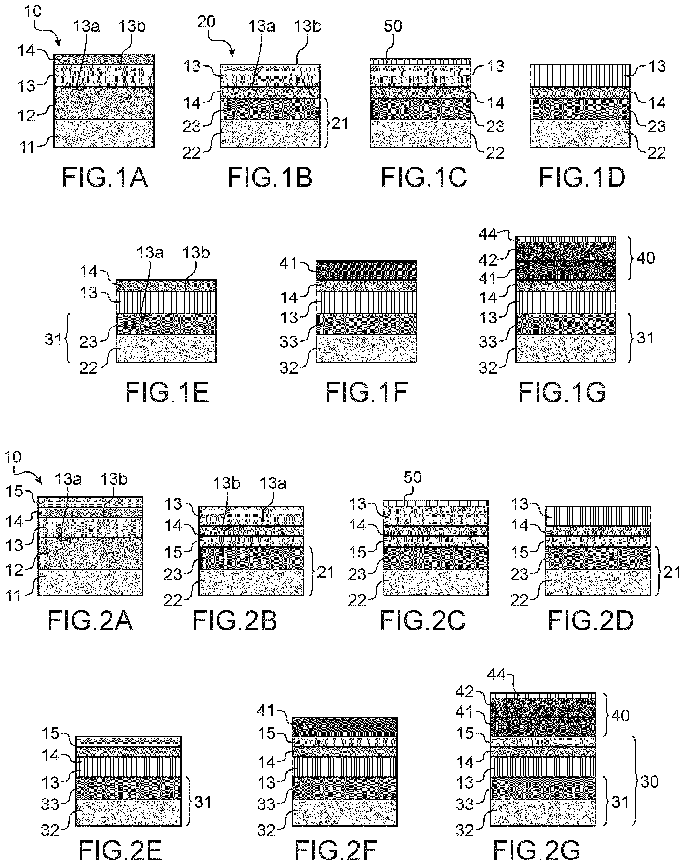

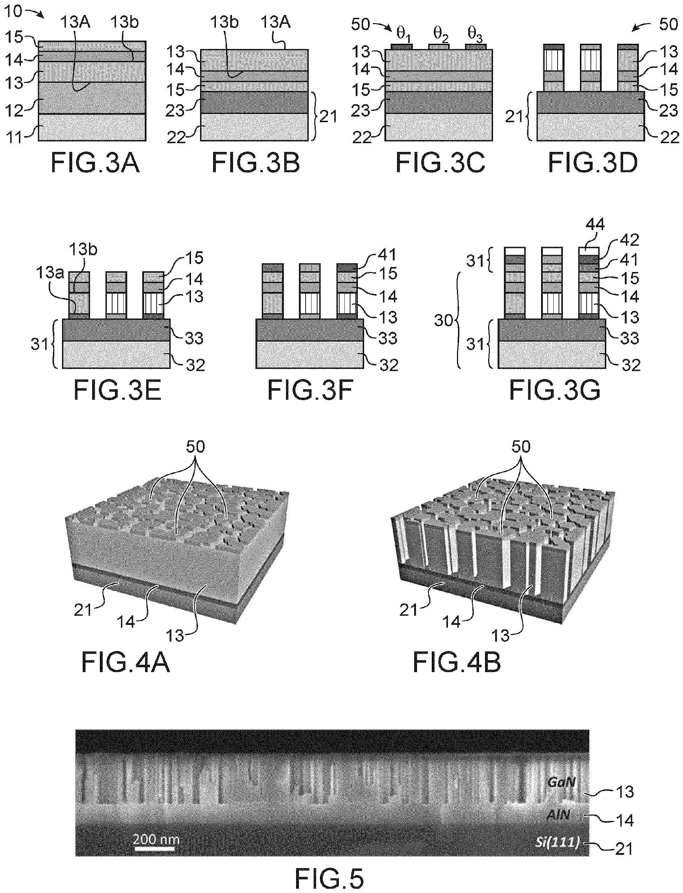

Les figure 1A, 1B, 1C, 1D, 1E et 1F Figure 1G représentent, de manière schématique et en coupe, un procédé de fabrication d'une structure LED comprenant une couche d'InGaN épitaxiée relaxée, selon un mode de réalisation particulier de l'invention. Les figures 2A, 2B, 2C, 2D, 2E, 2F et 2G représentent, de manière schématique et en coupe, un procédé de fabrication d'une structure LED comprenant une couche d'InGaN épitaxiée relaxée selon un autre mode de réalisation particulier de l'invention, Les figures 3A, 3B, 3C, 3D 3E, 3F et 3G représentent, de manière schématique et en coupe, un procédé de fabrication d'une structure LED comprenant une couche d'InGaN épitaxiée relaxée selon un autre mode de réalisation particulier de l'invention. Les figures 4A et 4B représentent de manière schématique et en trois dimensions différentes étapes d'un procédé de sublimation d'une couche de GaN à travers un masque en $Si_xN_y$, la couche de GaN reposant une couche barrière d'AlN reportée sur un substrat de porosification en silicium (111) selon un mode de réalisation particulier de l'invention. La figure 5 est un cliché MEB d'une couche de GaN porosifiée à travers un masque en $Si_xN_y$, la couche de GaN reposant une couche barrière reportée sur un substrat de porosification en silicium (111) selon un mode de réalisation particulier de l'invention,

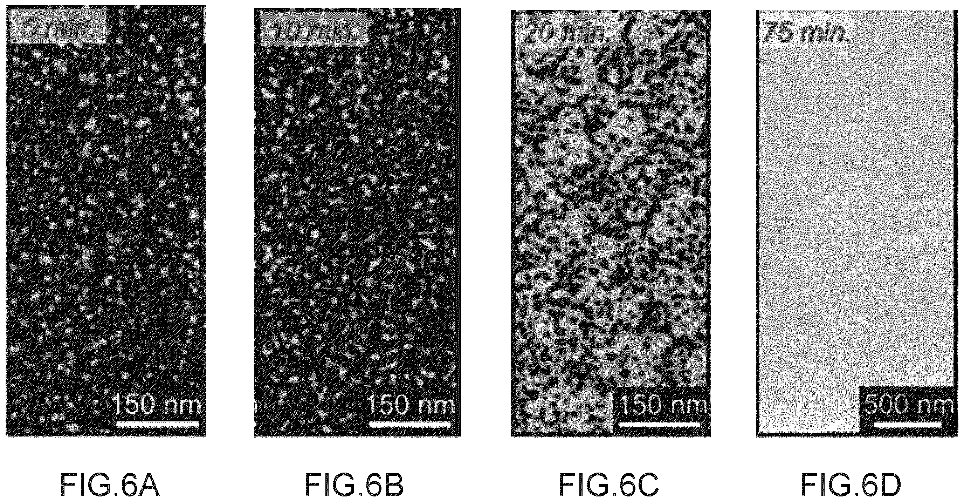

Les figure 6A, 6B, 6C et 6D sont des clichés obtenus au MEB montrant des nanomasques formés en exposant la surface de GaN à un flux de Si pendant 5min, 10min, 20min et 75min et soumis aux mêmes conditions de sublimation. Plus le temps de dépôt du nanomasque augmente, plus le taux de couverture en $Si_xN_y$ est élevé. Pour le temps le plus élevé, le taux de couverture est supérieur à 1, la surface de GaN est complètement recouverte de $Si_xN_y$.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

En outre, dans la description ci-après, des termes qui dépendent de l'orientation, tels que « dessus », «dessous », etc. d'une structure s'appliquent en considérant que la structure est orientée de la façon illustrée sur les figures.

**EXPOSÉ DÉTAILLÉ DE MODES DE RÉALISATION PARTICULIERS**

Bien que cela ne soit aucunement limitatif, l'invention trouve particulièrement des applications dans le domaine des micro-écrans couleurs, et plus particulièrement pour la fabrication des pixels rouge vert bleu. Cependant, elle pourrait être utilisée dans le domaine du photovoltaïque ou encore de l'électrolyse de l'eau (« water splitting ») puisque, d'une part, l'InGaN absorbe dans tout le spectre visible et que, d'autre part, ses bandes de valence et de conduction sont autour du domaine de stabilité de l'eau, conditions thermodynamiques nécessaires à la décomposition de l'eau. L'invention peut également être intéressante pour la fabrication de LED ou de laser émettant à grande longueur d'onde.

Le procédé, permettant d'obtenir un substrat ou un pseudo-substrat, comprenant au moins une couche barrière 14 sur une couche porosifiée de GaN ou d'InGaN 13, met en œuvre une étape au cours de laquelle on porosifie la couche de GaN ou d'InGaN 13 par anodisation électrochimique ou par sublimation.

Il est alors possible de réaliser une reprise d'épitaxie d'une couche d'InGaN sur la couche barrière. La couche d'InGaN épitaxiée est au moins partiellement relaxée, voire totalement relaxée, ce qui permet la croissance d'une structure LED.

Le pourcentage de relaxation correspond à :

$$\Delta a/a = (a_{c2} - a_{c1})/a_{c1}$$

avec $a_{c1}$, le paramètre de maille de la couche de départ, et
$a_{c2}$ le paramètre de maille de la couche relaxée
La couche est relaxée à 100% si $a_{c2}$ correspond au paramètre de maille du matériau massif.

Lorsque $a_{c1}=a_{c2}$ le couche est dite contrainte.
Par partiellement relaxée, on entend un pourcentage de relaxation supérieure à 50%.

Nous allons maintenant décrire plus en détail plusieurs procédés de fabrication d'un substrat recouvert par une couche d'InGaN épitaxiée relaxée en faisant référence aux différentes variantes de réalisation représentées sur les figures 1A à 1G, sur les figures 2A à 2G ainsi que sur les figures 3A à 3G.

Ces différentes variantes de réalisation comprennent au moins les étapes suivantes :

a) fournir un premier empilement 10 comprenant une couche à porosifier 13 en GaN ou InGaN et une couche barrière 14, de préférence en AlInN, AlN, GaN ou AlGaN (figures 1A, 2A, 3A),

b) reporter la couche à porosifier 13 en GaN ou InGaN et la couche barrière 14 sur un support de porosification 21, la couche barrière 14 étant disposée entre le support de porosification 21 et la couche à porosifier en GaN ou InGaN 13, de manière à former un deuxième empilement 20 (figures 1B, 2B, 3B),

c) former un masque 50 sur la couche à porosifier en GaN ou InGaN 13 (figures 1C, 2C, 3C),

d) porosifier la couche en GaN ou InGaN à travers le masque 50, moyennant quoi on forme une couche poreuse en GaN ou InGaN 13, puis retirer le masque 50 (figures 1D, 2D, 3D),

e) reporter la couche poreuse en GaN ou InGaN 13 et la couche barrière 14 sur un support d'intérêt 31 (figures 1E, 2E, 3E),

f) former une couche d'InGaN par épitaxie sur la couche barrière 14, moyennant quoi on obtient une couche d'InGaN épitaxiée relaxée (figures 1F, 2F, 3F),

g) de préférence, former une structure LED sur la couche d'InGaN épitaxiée (figures 1G, 2G, 3G),

h) éventuellement, former des mésas de taille micrométrique (par exemple de 1 $\mu$m à plusieurs dizaines de micromètres, et de préférence de 5 à 10 $\mu$m de côté) pour augmenter le pourcentage de relaxation, par relaxation par les bords libres des mésas.

L'étape h) peut être réalisée, par exemple, entre l'étape d) et l'étape e) et de préférence entre l'étape e) et l'étape f).

Le premier empilement 10 fourni à l'étape a) et, représenté sur les figures 1A, 2A, 3A, comprend de préférence un substrat initial 11, une couche de croissance 12, une couche à porosifier en GaN ou InGaN 13 et une couche barrière 14.

Le substrat initial 11 est par exemple, en saphir, en SiC, en silicium ou en verre. Le substrat 11 a, par exemple, une épaisseur allant de 350 $\mu$m à 1,5 mm.

La couche de croissance 12 en GaN 12 a, par exemple, une épaisseur allant de 30 nm à 4 $\mu$m. La couche de GaN est, de préférence, non intentionnellement dopée. Par GaN non intentionnellement dopée, on entend une concentration de dopage inférieure à $5.10^{17}$/cm$^3$, par exemple de $1.10^{17}$/cm$^3$. Alternativement, la couche de croissance 12 peut être en AlN ou AlGaN.

La couche à porosifier 13 d'InGaN ou de GaN peut être dopée, notamment avec un dopage de type n. Elle a, par exemple, une épaisseur allant de 10 à 200 nm pour de l'InGaN ou de 800nm à quelques micromètres (par exemple 2$\mu$m) pour du GaN. Une couche de plus faible épaisseur peut contenir une concentration en In élevée tout en conservant une bonne qualité matériau (peu de défaut). Par InGaN dopée, on entend une concentration en électrons comprise entre $2.10^{18}$ et $2.10^{19}$/cm$^3$. La couche d'InGaN dopée 13 est électriquement conductrice. Elle est porosifiée lors de l'étape d).

La couche d'InGaN ou de GaN 13 a deux faces principales : une première face principale 13a et une deuxième face principale 13b. La première face principale 13a est de polarité azote (N). Elle est disposée en regard de la couche de croissance en GaN 12. La deuxième face principale 13b est de polarité Gallium (Ga). Elle est disposée en contact avec la couche barrière 14.

La couche barrière 14 est de préférence en AlInN, AlN, GaN ou AlGaN. On choisira par exemple une couche barrière en AlInN.

La couche barrière 14 a, de préférence, une épaisseur inférieure à 3 nm, par exemple, une épaisseur de 1 nm. Sa concentration en In devra être ajustée de façon à être en accord de maille avec la couche en GaN ou InGaN 13. La couche barrière 14 va servir à la fois de couche sélective par rapport à la technique de sublimation et de couche de reprise d'épitaxie. La technique de sublimation n'aura pas d'effet sur la couche barrière 14. Cette couche n'est pas porosifiée lors de l'étape d). A l'issue de l'étape d), la couche barrière 14 n'est pas poreuse (c'est-à-dire qu'elle a une porosité inférieure à 0,01%, et de préférence inférieure à 0,001%). La couche barrière 14 est une couche non porosifiée pouvant servir à la reprise d'épitaxie.

Selon une première variante de réalisation, représentée sur la figure 1A, le premier empilement 10 est constitué des couches précédemment citées. Autrement dit, il ne comporte pas d'autres couches.

Selon une autre variante de réalisation représentée sur la figure 2A ou sur la figure 3A, le premier empilement comprend en outre une couche d'InGaN additionnelle 15. Cette couche additionnelle présente une concentration en In supérieure ou égale à celle de la couche d'InGaN 13, positionnée entre la couche de croissance en GaN 12 et la couche barrière 14. La croissance de cette couche additionnelle est réalisée sur la couche barrière 14. Après le premier transfert, la couche additionnelle est en contact avec le substrat de porosification 21 (figures 2B, 3B). Elle n'est pas porosifiée lors de l'étape d) (figures 2D, 3D). Après le second transfert, la couche additionnelle 15 est la couche supérieure de l'empilement (figures 2E, 3E) et ainsi la reprise d'épitaxie est réalisée directement à partir de cette couche 15 (figures 2F, 3F). Avantageusement, la présence de cette couche 15 évite ou limite d'éventuels problèmes de contamination de surface, entre les différentes étapes, due à la présence d'Al. De plus, lorsque la couche d'InGaN additionnelle 15 en surface de l'empilement a une concentration en In supérieure à la couche qui sera porosifiée, une première relaxation peut se produire après le second transfert et/ou après la formation des mésas.

Les couches du premier empilement 10 sont, avantageusement, déposées pleine plaque sur le substrat initial 11.

Lors de l'étape b), on transfert la couche barrière 14, la couche d'InGaN ou de GaN 13, et éventuellement la couche additionnelle 15 en InGaN sur un support de porosification 21 (figures 1B, 2B, 3B).

Le support de porosification 21 comprend, avantageusement, une couche support 22 et une couche d'oxyde enterré 23 dite BOX (« Buried Oxide layer » aussi parfois appelée couche continue d'oxyde).

La couche support (ou support) 22 est, par exemple, en saphir, en silicium, en carbure de silicium ou en verre. La couche support 22 a, par exemple, une épaisseur allant de 350 $\mu$m à 1,5 mm.

La couche d'oxyde 23 BOX a, par exemple, une épaisseur allant de 100 nm à 4 $\mu$m.

La face libre de la couche barrière 14 ou de la couche additionnelle 15 en InGaN est reportée, sur le support de porosification 21, de préférence, sur la couche d'oxyde 23 BOX du support de porosification 21, via par exemple un collage direct ou moléculaire.

Selon un mode de réalisation avantageux, ce transfert est réalisé par la technique du Smart Cut™. Pour cela, le procédé comporte les étapes suivantes :

- implantation d'espèces atomiques pour former une zone de fragilisation dans la couche à porosifier de GaN ou d'InGaN 13, à une profondeur voisine de l'épaisseur finale de la couche à conserver dans le substrat final ;
- collage du premier empilement 10 sur le support de porosification 21,
- apport d'énergie thermique pour désolidariser la couche d'InGaN ou de GaN 13 au niveau de la zone de fragilisation.

Le substrat initial 11 et la couche de GaN 12 du premier empilement 10 sont détachés de la couche d'InGaN/GaN 13 par fracture le long du plan de la zone de fragilisation. La fracture est réalisée par exemple, par traitement thermique dans une gamme de température allant de 400°C à 600°C et pendant une durée allant de quelques minutes à quelques heures. Cette fracture conduit au report de la couche à porosifier 13, de la couche barrière 14 et éventuellement de la couche additionnelle 15 sur le support de porosification 21.

Selon un mode de réalisation particulier, le substrat initial 11 et la couche de GaN 12 peuvent être détachés de la couche de GaN 13 par un procédé de gravure d'une couche intermédiaire sacrificielle par exemple avec un laser (aussi appelée technique de décollement ou « lift off »).

A l'issue de l'étape b), on obtient ainsi un deuxième empilement 20 comprenant successivement la couche support 22, la couche d'oxyde enterré 23, la couche barrière 14, la couche d'InGaN ou de GaN à porosifier 13 (figures 1B, 2B, 3B). La première face 13a de polarité N est ainsi accessible. Le deuxième empilement 20 peut comprendre en outre la couche additionnelle en InGaN 15. La couche additionnelle 15 est positionnée entre la couche d'oxyde enterrée 23 et la couche barrière 14.

Après implantation du Smart Cut™, et avant l'étape de porosification, il est possible de réaliser une étape d'implantation Si pour rendre la couche InGaN 13 électriquement conductrice ou encore plus électriquement conductrice si cette couche est déjà dopée.

Lors de l'étape c), on forme un masque 50 sur la couche à porosifier 13. Le masque comporte une pluralité d'ouvertures (ou pores). Les ouvertures peuvent être de dimensions identiques ou différentes. Avantageusement, leurs dimensions sont identiques. Les ouvertures peuvent être disposées régulièrement ou aléatoirement. Les ouvertures ont, par exemple, un diamètre de 10nm à 20nm. Les ouvertures sont, avantageusement, circulaires.

Le masque peut être formé d'une fraction de monocouche de matériau. Il a, par exemple, une épaisseur comprise entre 0,4 et 1 monocouche.

Il est possible de former un masque 50 pleine plaque, i.e. de dimensions identiques à la couche sousjacente à porosifier (figures 1C, 2C).

Selon un mode de réalisation particulier, représenté sur la figure 3C, le masque 50 est réalisé de façon à former trois zones différentes notées $\theta_1$, $\theta_2$, $\theta_3$, ayant des taux de couvertures différentes. Les dimensions du nanomasquage de chacune des trois zones vont piloter le degré de porosité de chaque zone lors de l'étape de sublimation.

La nature du masque 50 est choisie en fonction de la technique utilisée pour la porosification.

Pour une porosification par sublimation, on choisira avantageusement un masque 50 en SiN. Un tel masque peut être formé *in situ* ou *ex situ,* via un masquage intermédiaire avec un masque additionnel, par exemple en matériau polymère. Dans le cas d'un masquage ex situ, le masque SiN a, avantageusement, une épaisseur supérieure à 1 mono-couche. De préférence, le masque additionnel est un film de copolymère à bloc. Un film copolymère à blocs présente un grand nombre d'ouvertures (ou pores) de petites dimensions. Avantageusement, les ouvertures ont les mêmes dimensions et/ou sont régulièrement espacées, ce qui conduit, avantageusement, à l'obtention d'une couche de GaN/InGaN de porosité organisée. Avantageusement, un tel masque est formé rapidement. Par exemple, le copolymère à bloc est poly(styrène-blockméthyl méthacrylate) aussi noté PS-b-PMMA.

Le masque 50 est gravé en regard des ouvertures du masque additionnel pour former les ouvertures du masque 50.

Avantageusement à l'issue de l'étape c), le film additionnel de copolymère est retiré avant la porosification par sublimation.

Pour une porosification par voie électrochimique, on choisira un masque 50, de préférence en polymère. Par exemple, le masque 50 est un film de copolymère à bloc. De préférence, le copolymère à bloc est le PS-b-PMMA.

Alternativement, il est possible d'utiliser un masque 50 en alumine poreuse. Le masque 50 en alumine nanoporeuse peut être obtenu en structurant une feuille d'aluminium grâce à différentes étapes d'oxydation et de gravure. Les nano-pores du masque 50 en alumine ont avantageusement un diamètre entre 15 et 400nm, par exemple 80nm, et un pas entre 50nm et 400nm, par exemple de l'ordre de 100 nm. L'épaisseur du masque 50 en alumine est par exemple de 250nm.

Lors de l'étape d), on porosifie la couche 13 de GaN ou d'InGaN par sublimation ou par voie électrochimique.

Pour réaliser la porosification par sublimation, on pourra utiliser par exemple un bâti d'épitaxie par jet moléculaire (EJM ou MBE pour « Molecular Beam Epitaxy ») ou un bâti d'épitaxie en phase vapeur aux organométalliques (EPVOM). L'épitaxie par EJM permet un contrôle *in situ* de la croissance, à la monocouche près. La porosification par sublimation conduit avantageusement à l'obtention de pores bien définis, et notamment de forme cylindrique. La paroi latérale des pores est perpendiculaire aux faces principales 13a, 13b de la couche 13.

On choisira, par exemple des températures de 800°C à 900°C pour la sublimation sous vide MBE. Plus la température est élevée, plus la vitesse de sublimation est importante.

La couche barrière 14 joue le rôle de couche d'arrêt de la sublimation. Cette couche n'est pas sublimée. Elle protège les couches sous-jacentes lors de la porosification. Elle joue le rôle de couche barrière ou de couche d'arrêt. En particulier, dans le cas d'un premier empilement comprenant une couche additionnelle en InGaN 15, cette dernière est protégée par la couche barrière 14 lors de la sublimation.

Avec cette technique de porosification, la couche de GaN ou d'InGaN 13 peut être dopée ou non dopée.

Pour réaliser la porosification par voie électrochimique, la couche à porosifier doit être électriquement conductrice. On choisira donc une couche de GaN dopée ou d'InGaN dopée. La porosification est appliquée sur la face N de la couche de GaN ou InGaN en surface. Avantageusement, la porosification par la face N conduit à une porosification plus importante (taux de porosité, forme des pores).

L'étape c) comprend, par exemple, les sous-étapes suivantes :

- connecter la couche de GaN ou d'InGaN dopée 13 et une contre-électrode à un générateur de tension ou de courant,

- plonger le deuxième empilement 20 et la contre-électrode dans une solution électrolytique,

- appliquer une tension ou un courant, entre la couche de GaN ou d'InGaN dopée 13 et la contre-électrode de manière à porosifier la couche de GaN ou d'InGaN dopée 13.

Le deuxième empilement 20 joue le rôle d'électrode de travail (WE).

La contre-électrode est en un matériau électriquement conducteur. Le matériau de la contre-électrode sera choisi de manière à ne pas pouvoir former de sous-produits oxydables lors de la réaction cathodique, afin de ne pas induire de modification de l'électrolyte lors la porosification. On choisira, par exemple, un métal tel que le platine.

Lors de l'étape d), les électrodes sont plongées dans un électrolyte, aussi appelé bain électrolytique ou solution électrolytique. L'électrolyte peut être acide ou basique. L'électrolyte est, par exemple, de l'acide oxalique. Il peut également s'agir de KOH, HF, $HNO_3$ ou $H_2SO_4$.

On applique une tension entre le dispositif et la contre-électrode. La tension peut aller de 1V à 100V, de préférence de 3V à 100 V. Elle est appliquée, par exemple, pendant une durée allant de quelques secondes à quelques heures. La réaction d'anodisation est finie lorsque, à potentiel imposé, le courant devient nul : dans ce cas il n'y a plus de transfert de charges et la réaction électrochimique s'arrête.

L'étape d'anodisation électrochimique peut être réalisée sous lumière ultra-violette (UV). Le procédé peut également comporter une première anodisation électrochimique sans ajouter de rayonnement ultra-violet et une seconde anodisation électrochimique en ajoutant un rayonnement ultra-violet.

Avantageusement, la porosification a lieu dans tout le volume de la couche de GaN ou d'InGaN dopée 13.

A l'issue de l'étape de porosification d), le taux de porosité de la couche de GaN ou d'InGaN dopée 13 est d'au moins 1%. Il va de préférence de 5% à 70%

La plus grande dimension (la hauteur) des pores peut varier de quelques nanomètres à quelques micromètres. La plus petite dimension (le diamètre) peut varier de quelques nanomètres à une centaine de nanomètres, en particulier de 10nm à 70nm, par exemple de 10 à 20 nm ou de 30 à 70nm, et de préférence de 15nm à 40nm.

La porosification obtenue (taux de porosité et taille des pores) dépend de la géométrie du masque 50, éventuellement du dopage de la couche 13 de GaN ou d'InGaN et des paramètres du procédé (tension appliquée, durée, nature et concentration de l'électrolyte pour la porosification par voie électrochimique ou durée et température pour la sublimation). La variation de la porosification permet de contrôler le taux d'incorporation / ségrégation de l'In. La porosification, et en particulier, la taille des pores, pourra varier ultérieurement, lors de la reprise d'épitaxie en fonction de la température appliquée.

Lors de l'étape e), on reporte ensuite le deuxième empilement 20 comprenant la couche porosifiée 13 de GaN ou d'InGaN, la couche barrière 14, et éventuellement, la couche additionnelle 15, sur le support d'intérêt 31 (figures 1E, 2E, 3E) pour avoir la deuxième face 13b de polarité métal (Gallium) en face avant. Le support d'intérêt 31 comprend, par exemple, une couche support 32 de préférence en Si, SiC, verre ou saphir, et une couche d'oxyde BOX 33. On choisira un oxyde pouvant supporter l'épitaxie à haute température (au moins 950°C).

On obtient ainsi à l'issue du procédé un substrat 30 de type InGaNOX (« InGaN on substrate X ») comprenant depuis la face arrière vers la face avant (figures 1E, 2E, 3E) :

- un support d'intérêt 31, de préférence, formé d'une couche support 32, par exemple en saphir, et d'une couche d'oxyde BOX 33,
- une couche de GaN ou d'InGaN 13, porosifiée, avec une polarité Ga en face avant,
- une couche barrière 14, non poreuse,
- et éventuellement une couche d'InGaN additionnelle 15.

A l'issue de l'étape e), la couche barrière 14 ou la couche additionnelle 15 en InGaN se retrouve en face avant. Ces couches sont denses (i.e. elles ne sont pas poreuses).

Lors de l'étape f), on forme une couche d'InGaN par reprise d'épitaxie. La couche barrière 14 et/ou la couche d'InGaN additionnelle 15 est une couche 2D continue non poreuse puisqu'elle n'est pas porosifiée lors de l'étape d'anodisation électrochimique ou de sublimation. La couche barrière 14 ou la couche additionnelle 15 va permettre de reprendre l'épitaxie avec une couche d'InGaN de concentration en In supérieure à la couche GaN ou InGaN du dessous. La croissance de l'empilement réépitaxié 40 est ainsi facilitée et la couche épitaxiée présente une meilleure qualité cristalline.

La couche d'InGaN de surface guidera la déformation de la couche poreuse par sa concentration en In et son épaisseur. La couche poreuse peut être amenée à se déformer de façon à ce que la couche d'InGaN de surface puisse se relaxer. Des taux de relaxation de l'ordre de 70%, voire plus peuvent être avantageusement obtenus.

Selon une variante de réalisation avantageuse, le procédé peut comporter une étape au cours de laquelle on structure la couche d'InGaN ou de GaN et la couche barrière 14 pour former des mésas (étape h).

Les mésas, aussi appelées élévations, sont des éléments en relief. Elles sont obtenues, par exemple, par gravure d'une couche continue ou de plusieurs couches continues superposées, de manière à ne laisser subsister qu'un certain nombre de "reliefs" de cette couche ou de ces couches. La gravure est généralement une gravure plasma ou sèche (ex : RIE plasma). Les reliefs permettent de définir des pixels.

De préférence, les flancs des mésas sont perpendiculaires à l'empilement des différentes couches du substrat 30.

Les dimensions (largeur et longueur) des mésas vont de 500nm à 500μm. Par largeur et longueur, on entend les dimensions parallèles à la surface de l'empilement sous-jacent. On choisira, notamment, des dimensions inférieures ou égales à 10μm × 10μm.

L'espacement (« pitch ») entre deux mésas 100 consécutives peut être compris entre 50nm et 20μm.

Les mésas comprennent la couche d'InGaN ou de GaN 13, la couche barrière 14 et éventuellement la couche additionnelle 15.

L'épaisseur des mésas dépend notamment de l'épaisseur de la couche d'InGaN ou de GaN 13. Par exemple, pour une couche 13 en GaN poreux, la hauteur de la mésa peut être de 700 nm (500 nm GaN poreux + 200 nm d'InGaN non poreux). Par épaisseur, on entend la dimension de la mésa perpendiculaire à l'empilement sous-jacent.

Les mésas sont formées, avantageusement, avant la croissance de la structure LED, et encore plus avantageusement avant la reprise d'épitaxie.

Selon une autre variante de réalisation avantageuse les mésas sont, avantageusement, formées après l'étape de porosification.

Selon une autre variante de réalisation avantageuse, les mésas peuvent être formées avant l'étape de porosification. Par exemple, après l'étape de masquage (étape c), une lithographie peut ensuite effectuée pour obtenir des mésas. Il est, notamment avantageux de former une mésa par zone θ1, θ2, θ3 de nanomasque. De préférence, une seule étape de sublimation est réalisée pour les 3 zones.

Selon une autre variante de réalisation, les mésas sont formées avant ou après la reprise d'épitaxie de la couche d'InGaN.

Les mésas peuvent être structurées puis dopées. Selon cette variante de réalisation, le procédé peut comporter, avant l'étape de porosification, les étapes suivantes :

- structurer la couche d'InGaN ou de GaN 13 et la couche barrière 14, déposées pleine plaque, pour former des mésas,
- avantageusement, remplir l'espace entre les mésas avec un matériau adapté et planariser l'ensemble ainsi obtenu pour avoir une surface plane,
- implanter localement un dopant dans les mésas à la même concentration ou à des concentrations différentes ; il est par exemple possible de réaliser plusieurs implantations avec des jeux de masques différents.

Alternativement, le dopage peut être réalisé préalablement à la structuration des mésas. Selon cette variante de réalisation, le procédé peut comporter, avant l'étape de porosification, les étapes suivantes :

- implanter localement un dopant dans la couche 13 d'InGaN ou de GaN déposée pleine plaque, la concentration en dopant pouvant varier le long de la couche de manière à former des zones plus ou moins dopées,
- structurer la couche d'InGaN ou de GaN 13 et la couche barrière 14, déposées pleine plaque, pour former des mésas.

A titre illustratif, il est, par exemple, possible d'utiliser un masque dur, comme un masque de type SiN ou SiO$_2$, pour réaliser l'implantation et des marques d'alignement (par exemple en Al, Ti, TiN) pour faire correspondre les mésas et les zones implantées. Avec deux masques différents, deux zones avec des énergies d'implantation différentes peuvent être réalisées, et donc deux dopages différents en plus du dopage initial de la plaque dopée, par exemple par MOCVD. Les marques d'alignement permettent d'aligner les deux masques pour l'implantation et le masque pour la gravure des mésas.

Le même jeu de masque sera utilisé pour l'implantation et les mésas.

La structuration des mésas peut être réalisée par photolithographie.

Alternativement, le dopage par implantation peut être remplacé par un dopage par épitaxie en phase vapeur aux organométalliques (MOCVD), avec comme dopant Si ou Ge notamment. Il est, par exemple, possible de réaliser trois étapes d'épitaxie successives pour obtenir 3 niveaux de dopages différents afin de former à la fin du procédé des mésas bleues, vertes et rouges (RGB).

De préférence, le procédé comporte une étape ultérieure au cours de laquelle on forme une structure LED sur la couche d'InGaN épitaxiée (étape g).

Cette étape est avantageusement réalisée pour former des LED ré-épitaxiées, en particulier des LED rouges (ou vertes) tout InGaN.

La structure LED est avantageusement réalisée sur les mésas. Ces dernières ayant un paramètre de maille dans le plan supérieur à celui du GaN grâce à la relaxation, elles serviront de pseudo-substrat InGaN pour augmenter le taux d'incorporation d'In dans la structure LED tout InGaN. Cela permettra aussi de conserver une bonne qualité cristalline malgré la forte teneur en In.

De manière encore plus avantageuse, la reprise d'épitaxie est réalisée sur des mésas ayant différents degrés de porosité. Lors de cette étape, la concentration en In de la couche d'InGaN réépitaxiée dans chacune des zones va varier car le taux de relaxation de chacune des mésas était déjà différent avant reprise d'épitaxie (par exemple si la couche d'InGaN additionnelle 15 disposée sur la couche barrière 14 a une concentration en In supérieure de la couche porosifiée). Alors, il est possible d'épitaxier la structure LED tout InGaN. La concentration en In des différentes couches de la structure va être guidée par le taux de relaxation. Ainsi si chacune des mésas a le paramètre de maille adéquat, une seule étape de croissance permet d'obtenir les trois couleurs RGB, chaque mésa ayant une couleur. Les paramètres de maille a nécessaires sont : 3.184Å pour le bleu, 3.200Å pour le vert, et 3.238Å pour le rouge.

L'empilement réépitaxié 40 d'une LED tout InGaN comprend, par exemple, successivement depuis la couche barrière 14 ou, le cas échéant depuis la couche additionnelle d'InGaN 15 :

- une couche d'In$_x$Ga$_{1-x}$N dopée n 41 (couche simple ou en super réseaux InGaN/GaN), de préférence de même concentration en In que la couche d'InGaN du substrat relaxé,
- une zone active 42 avec un ou plusieurs puits quantiques In$_y$Ga$_{1-y}$N/In$_x$Ga$_{1-x}$N (généralement 5), émettant dans le rouge (ou bleu ou vert pour obtenir au final les 3 couleurs RGB),
- une barrière à électron 43 à base de GaN ou d'AlGaN dopée p (xAl ~ 10%),
- une couche d'In$_x$Ga$_{1-x}$N dopée p 44, de préférence de même concentration en In que la couche de n-InGaN ou inférieure,
- une couche d'InGaN dopée p++ 45, de préférence de même concentration en In que la couche de p-InGaN.

Plus particulièrement, une structure LED tout InGaN peut comprendre successivement :

- un substrat InGaN,
- une couche d'InGaN dopée n de 350nm, formée de 15 x In$_{0,03}$Ga$_{0,97}$N / GaN (épaisseurs 20nm / 1,8nm),
- des puits quantiques multiples (MQWs), formés de 5 x In$_{0,40}$Ga$_{0,60}$N / In$_{0,03}$Ga$_{0,097}$N (épaisseurs 2,3nm / 5, 7, 11 nm),
- une couche de In$_{0,03}$Ga$_{0,97}$N nid (10nm),- une couche Al$_{0,1}$Ga$_{0,9}$N :Mg (20nm),
- une couche de In$_{0,03}$Ga$_{0,97}$N dopée Mg (125nm),
- une couche de In$_{0,03}$Ga$_{0,97}$N dopée p+++ (25nm).

Différents procédés de croissance peuvent être utilisés pour former des couches épitaxiées.

Selon une première variante de réalisation, la reprise de croissance est latérale et une étape de pixellisation ultérieure par gravure est avantageusement réalisée.

Selon une autre variante de réalisation, la reprise de croissance se fait verticalement au-dessus des mésas. Dans cette variante, les pixels correspondent aux mésas sous-jacentes.

Avantageusement, une couche de passivation sera déposée sur les flancs des mésas et/ou des LED ré-épitaxiées par exemple par dépôt de couche atomique (ALD). La couche de passivation peut être en alumine. La couche de passivation peut avoir une épaisseur de quelques nanomètres, par exemple de 2 à 5nm.

Un procédé technologique sera finalement appliqué pour la fabrication des micro-LEDs. Les micro-LEDs peuvent être de la taille initiale des mésas.

Exemple illustratif et non limitatif :

La figure 4A présente de manière schématique une couche de GaN à porosifier par sublimation. La couche de GaN est sur un substrat comprenant un support de silicium et une couche barrière en AIN. Un nanomasquage est réalisé in-situ en déposant du SiN. La porosification se fait à travers les trous du masque grâce à une étape de sublimation sous vide. La figure 4B représente schématiquement l'échantillon après porosification par sublimation à travers le masque de SiN.

Une caractérisation par microscope électronique à balayage (MEB) confirme que la porosification a bien été réalisée (figure 5). La couche d'AIN est intacte : elle n'a pas été porosifiée.

Les figures 6A à 6D montrent l'influence du taux de couverture du nanomasquage in-situ SiN (de 0 à 1 monocouche) sur le taux de porosité d'une couche de GaN après l'étape de sublimation.

## REFERENCES

[1] A. Even et al., "Enhanced In incorporation in full InGaN heterostructure grown on relaxed InGaN pseudo-substrate », Appl. Phys. Lett. 110, 262103 (2017).

[2] S. Pasayat et al., « Compliant Micron-Sized Patterned InGaN Pseudo-Substrates Utilizing Porous GaN", Materials 13, 213 (2020).

[3] S. Pasayat et al., "Démonstration of ultra-small (<10 μm) 632 nm red InGaN micro-LEDs with useful on-wafer external quantum efficiency (>0.2%) for minidisplays", "Appl. Phys. Exp. 14, 011004 (2021).

[4] EP 3 840 065 A1.

[5] EP 3 840 016 A1.

[6] B. Damilano, et al., "Photoluminescence properties of porous GaN and (Ga,In)N/GaN single quantum well made by selective area sublimation," Optics Express 25, 33243 (2017).

[7] P.-M. Coulon, P. Feng, B. Damilano, S. Vézian, T. Wang, and P. A. Shields, "Influence of the reactor environment on the selective area thermal etching of GaN nanohole arrays," Scientific Reports 10, (2020). https://doi.org/10.1038/s41598-020-62539-1.

## Revendications

1. Procédé pour fabriquer une couche d'InGaN épitaxiée relaxée à partir d'un substrat GaN/InGaN comprenant les étapes suivantes :

   a) fournir un premier empilement (10) comprenant successivement une couche à porosifier en GaN ou InGaN (13) et une couche barrière (14) de préférence en AlInN, AIN, GaN ou AIGaN,

   b) reporter la couche à porosifier en GaN ou InGaN (13) et la couche barrière (14) sur un support de porosification (21), la couche barrière (14) étant disposée entre le support de porosification (21) et la couche à porosifier en GaN ou InGaN (13), de manière à former un deuxième empilement (20),

   c) former un masque (50) sur la couche à porosifier en GaN ou InGaN (13),

   d) porosifier la couche en GaN ou InGaN (13) à travers le masque, moyennant quoi on forme une couche poreuse en GaN ou InGaN (13),

   e) reporter la couche poreuse en GaN ou InGaN (13) et la couche barrière (14) sur un support d'intérêt (31), la couche poreuse en GaN ou InGaN (13) étant disposée entre le support d'intérêt 31 et la couche barrière (14), moyennant quoi on forme un substrat intermédiaire,

   f) former une couche d'InGaN (41) par épitaxie sur le substrat intermédiaire, moyennant quoi on obtient une couche d'InGaN épitaxiée relaxée sur le substrat intermédiaire.

2. Procédé selon la revendication 1, **caractérisé en ce que** l'étape d) est réalisée par sublimation à travers le masque (50), le masque (50) étant de préférence en SiN.

3. Procédé selon la revendication 1, **caractérisé en ce que** la couche à porosifier (13) est dopée et **en ce que** l'étape d) est réalisée par voie électrochimique à travers le masque (50).

4. Procédé selon la revendication 3, **caractérisé en ce que** le masque (50) est en un matériau polymère, de préférence un copolymère à bloc.

5. Procédé selon l'une quelconque des revendications précédentes, **caractérisé en ce que** le masque (50) formé à l'étape c) a des ouvertures de 20 nm à 40nm de diamètre.

6. Procédé selon l'une quelconque des revendications précédentes, **caractérisé en ce que** le support de porosification (21) et/ou le support d'intérêt (31) comprend une couche support (22, 32), par exemple en saphir, en SiC ou en silicium, et une couche d'oxyde enterré (23, 33).

7. Procédé selon l'une quelconque des revendications précédentes, **caractérisé en ce que** le premier empilement (10) fourni à l'étape a) comprend en outre une couche d'InGaN additionnelle (15) recouvrant la couche barrière (14) et **en ce que** lors de l'étape b), la couche d'InGaN additionnelle (15) est disposée entre le support de porosification (21) et la couche barrière (14).

8. Procédé selon l'une quelconque des revendications précédentes, **caractérisé en ce que** le procédé comprend une étape additionnelle au cours de laquelle on réalise une étape de dopage par implantation ou par épitaxie en phase vapeur aux organométalliques, éventuellement avec différents dopages, sur la couche de GaN ou d'InGaN (13).

9. Procédé selon l'une quelconque des revendications précédentes, **caractérisé en ce que** le masque (50) formé à l'étape c) est déposé localement sur la couche à porosifier en GaN ou InGaN (13), moyennant quoi, lors de l'étape d), on forme des mésas de GaN ou d'InGaN.

10. Procédé selon l'une quelconque des revendications précédentes, **caractérisé en ce que** le masque (50) présente comporte au moins une première zone ($\theta_1$), une deuxième zone ($\theta_2$) et une troisième zone ($\theta_3$), les ouvertures de la première zone ($\theta_1$) ayant une première dimension, les ouvertures de la deuxième zone ($\theta_2$) ayant une deuxième dimension et les ouvertures de la troisième zone ($\theta_3$) ayant une troisième dimension, moyennant quoi lors de l'étape d) la couche poreuse en GaN ou InGaN (13) présente un premier degré de porosité, un deuxième degré de porosité et un troisième de degré de porosité en regard respectivement de la première zone ($\theta_1$), de la deuxième zone ($\theta_2$) et de la troisième zone ($\theta_3$).

11. Substrat (30) comprenant successivement :

    - un support d'intérêt (31), comprenant par exemple une couche support (32), par exemple en saphir, en SiC ou en silicium, et une couche d'oxyde enterré (33),
    - une couche poreuse en GaN ou InGaN (13), ayant, avantageusement, une porosité supérieure à 1%, et
    - une couche barrière (14),
    - une couche additionnelle en InGaN (15).

12. Diode électroluminescente comprenant successivement : un substrat (30) et un empilement réépitaxié (40),

    le substrat (30) comprenant :

        - un support d'intérêt (31),
        - une couche poreuse en GaN ou InGaN (13),
        - une couche barrière (14),
        - éventuellement une couche additionnelle en InGaN (15).

    l'empilement réépitaxié (40) comprenant successivement depuis la couche barrière (14) ou le cas échéant depuis la couche additionnelle en InGaN (15) :

        - une couche d'InGaN épitaxiée relaxée dopée d'un premier type de conductivité (41),
        - une zone active (42) avec un ou plusieurs puits quantiques InGaN/(Ga,In)N émettant dans le rouge ou dans les vert,
        - une couche d'InGaN dopée d'un second type de conductivité, différent du premier type de conductivité (44).

FIG.1A

FIG.1B

FIG.1C

FIG.1D

FIG.1E

FIG.1F

FIG.1G

FIG.2A

FIG.2B

FIG.2C

FIG.2D

FIG.2E

FIG.2F

FIG.2G

FIG.3A

FIG.3B

FIG.3C

FIG.3D

FIG.3E

FIG.3F

FIG.3G

FIG.4A

FIG.4B

FIG.5

FIG.6A

FIG.6B

FIG.6C

FIG.6D

Europäisches
Patentamt

European
Patent Office

Office européen
des brevets

# RAPPORT DE RECHERCHE EUROPEENNE

**Numéro de la demande**

**EP 22 17 7631**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2009/140274 A1 (WIERER JR JONATHAN J [US] ET AL) 4 juin 2009 (2009-06-04) | 11,12 | INV.<br>H01L33/00 |
| A | * alinéas [0023] - [0029], [0031], [0036], [0045] - [0050] *<br>* figures 1-7 * | 1-10 | H01L33/12<br>H01L21/02 |
| X,P | EP 3 840 016 A1 (COMMISSARIAT ENERGIE ATOMIQUE [FR]) 23 juin 2021 (2021-06-23)<br>* alinéas [0040], [0064] *<br>* figures 1c, 5 * | 11,12 | |
| A | JANG LEE-WOON ET AL: "Electrical and structural properties of GaN films and GaN/InGaN light-emitting diodes grown on porous GaN templates fabricated by combined electrochemical and photoelectrochemical etching",<br>JOURNAL OF ALLOYS AND COMPOUNDS, ELSEVIER SEQUOIA, LAUSANNE, CH,<br>vol. 589, 11 décembre 2013 (2013-12-11), pages 507-512, XP028815812,<br>ISSN: 0925-8388, DOI:<br>10.1016/J.JALLCOM.2013.12.034<br>* le document en entier * | 1,11 | DOMAINES TECHNIQUES RECHERCHES (IPC)<br><br>H01L |
| A | US 2015/318436 A1 (HEO JEONG HUN [KR] ET AL) 5 novembre 2015 (2015-11-05)<br>* alinéas [0061] - [0072] *<br>* figure 1 * | 1 | |

Le présent rapport a été établi pour toutes les revendications

| Lieu de la recherche | Date d'achèvement de la recherche | Examinateur |
|---|---|---|
| La Haye | 29 septembre 2022 | Gijsbertsen, Hans |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
........................................................................
& : membre de la même famille, document correspondant

EPO FORM 1503 03.82 (P04C02)

**EP 4 102 579 A1**

## ANNEXE AU RAPPORT DE RECHERCHE EUROPEENNE
## RELATIF A LA DEMANDE DE BREVET EUROPEEN NO.

EP 22 17 7631

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

29-09-2022

| Document brevet cité au rapport de recherche | Date de publication | Membre(s) de la famille de brevet(s) | Date de publication |
|---|---|---|---|
| US 2009140274 A1 | 04-06-2009 | US 2009140274 A1<br>US 2011193059 A1<br>US 2016284935 A1<br>US 2019103511 A1 | 04-06-2009<br>11-08-2011<br>29-09-2016<br>04-04-2019 |
| EP 3840016 A1 | 23-06-2021 | CN 113013018 A<br>EP 3840016 A1<br>FR 3105568 A1<br>US 2021193873 A1 | 22-06-2021<br>23-06-2021<br>25-06-2021<br>24-06-2021 |
| US 2015318436 A1 | 05-11-2015 | CN 103730544 A<br>TW 201415668 A<br>TW 201539787 A<br>US 2015318436 A1<br>WO 2014061906 A1 | 16-04-2014<br>16-04-2014<br>16-10-2015<br>05-11-2015<br>24-04-2014 |

EPO FORM P0460

Pour tout renseignement concernant cette annexe : voir Journal Officiel de l'Office européen des brevets, No.12/82

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 3840065 A1
- EP 3840016 A1

**Littérature non-brevet citée dans la description**

- **A. EVEN et al.** Enhanced In incorporation in full In-GaN heterostructure grown on relaxed InGaN pseudo-substrate. *Appl. Phys. Lett.,* 2017, vol. 110, 262103
- **S. PASAYAT et al.** Compliant Micron-Sized Patterned InGaN Pseudo-Substrates Utilizing Porous GaN. *Materials,* 2020, vol. 13, 213
- **S. PASAYAT et al.** Démonstration of ultra-small (<10 μm) 632 nm red InGaN micro-LEDs with useful on-wafer external quantum efficiency (>0.2%) for minidisplays. *Appl. Phys. Exp,* 2021, vol. 14, 011004
- **B. DAMILANO et al.** Photoluminescence properties of porous GaN and (Ga,In)N/GaN single quantum well made by selective area sublimation. *Optics Express,* 2017, vol. 25, 33243
- **P.-M. COULON ; P. FENG ; B. DAMILANO ; S. VÉZIAN ; T. WANG ; P. A. SHIELDS.** Influence of the reactor environment on the selective area thermal etching of GaN nanohole arrays. *Scientific Reports,* 2020, vol. 10, https://doi.org/10.1038/s41598-020-62539-1